# EUROPÄISCHE PATENTSCHRIFT

(11) **EP 0 618 506 B1**
(45) Veröffentlichungstag und Bekanntmachung des Hinweises auf die Patenterteilung: **10.12.1997**
(21) Anmeldenummer: 94103752.5
(22) Anmeldetag: 11.03.1994
(51) Int. Cl.: G03F 7/42

(54) **Entschichterlösung für lichtvernetzte Photoresistschablonen**
Stripping solution for photopolymerised resist stencils
Solution de décapage pour des réserves photopolymérisées

(30) Priorität: 31.03.1993 DE 9304878 U
(43) Veröffentlichungstag der Anmeldung: 05.10.1994
(73) Patentinhaber: Morton International, Inc., Chicago, Illinois 60606-1596 (US)
(72) Erfinder: Horn, Klaus, Dr., D-65179 Hofheim (DE); Lingnau, Jürgen, Dr., D-55130 Mainz (DE); Martens, Klaus-Peter, Dr., D-35606 Solms (DE)
(74) Vertreter: Bankes, Stephen Charles Digby

(56) Entgegenhaltungen:
- EP-A- 0 547 488
- JP-A- 1 310 356
- US-A- 4 165 295
- US-A- 4 215 005
- PATENT ABSTRACTS OF JAPAN vol. 14, no. 366 (P-1089)8. August 1990 & JP-A-02 135 352 (OKI ELECTRIC IND. CO. LTD.) 24. Mai 1990
- PATENT ABSTRACTS OF JAPAN vol. 15, no. 316 (P-1237)13. August 1991 & JP-A-03 113 450 (OKI ELECTRIC IND. CO. LTD.) 14. Mai 1990

## Beschreibung

Die Erfindung betrifft eine Lösung zum Entschichten von lichtvernetzten Photoresistschablonen.

Photoresistschablonen werden durch bildmäßiges Belichten von Photoresistschichten und Auswaschen der Nichtbildstellen mit einem geeigneten Lösemittel bzw. einer geeigneten Entwicklerlösung hergestellt. Negativ arbeitende Photoresists werden an den belichteten Stellen vernetzt oder polymerisisert und dadurch unlöslich, so daß die unbelichteten Stellen mit dem Entwickler ausgewaschen werden können. Die vernetzten bzw. polymerisierten Bildstellen weisen im allgemeinen eine hohe Resistenz gegenüber Verarbeitungschemikalien, wie Ätzlösungen oder galvanischen Bädern auf. Sie haben jedoch den Nachteil, daß sie sich nach dem Ätzen oder Galvanisieren schwieriger entfernen lassen als positiv arbeitende Schichten, bei denen die Löslichkeit der Bildstellen nicht durch Vernetzung vermindert wird. Besonders erschwert ist die Entfernung bzw. Entschichtung von Schablonen, die zusätzlich durch Erhitzen vernetzt werden. Solche Schablonen werden vor allem als Lötstoppmasken eingesetzt. Die hierfür verwendeten lichtempfindlichen photopolymerisierbaren Materialien enthalten zumeist polymere, in organischen Lösemitteln und ggf. in wäßrig-alkalischen Lösungen lösliche Bindemittel, radikalisch polymerisierbare Verbindungen, zumeist mehrfach ungesättigte Acryl- oder Methacrylsäureester, thermisch vernetzbare polymere oder oligomere Verbindungen, z. B. Epoxyharze, thermisch aktivierbare Härtungsmittel für die vernetzbaren Verbindungen, ggf. Farbstoffe oder Farbpigmente und farblose anorganische Pigmente, z.B. Siliciumdioxid, Magnesiumoxid, Bariumsulfat oder Calciumsilikat.
Bei der Entwicklung derartiger Materialien bilden sich häufig unlösliche Abscheidungen, die sich in Verarbeitungsmaschinen an Wänden, Rohrleitungen, Sprühdüsen und Heizschlangen festsetzen und kaum noch zu entfernen sind. Besonders kritisch ist es, wenn sich derartige Sedimente in Sprührohren und Sprühdüsen abscheiden und diese zusetzen.

Als Entschichtungslösungen für die oben bezeichneten durch Belichten und ggf. Erhitzen gehärteten Photoresist- oder Lötstoppmasken werden gewöhnlich relativ konzentrierte wäßrige Lösungen von Alkalihydroxiden oder quaternären Ammoniumbasen oder Gemische von organischen Lösemitteln untereinander oder mit solchen basischen wäßrigen oder rein organischen Lösungen eingesetzt. Wenn die zu entschichtenden Masken längere Zeit gelagert oder thermisch vernetzt worden sind, lassen sie sich mit den bekannten Entschichtungslösungen oft nicht mehr restlos entfernen. Bei längerer Einwirkung oder bei erhöhter Temperatur werden die Trägermaterialien der Leiterplatten angegriffen, z.B. wird das Glasfasergerüst von glasfaserverstärkten Kunstharz-Preßstoffplatten freigelegt, oder die Einzellagen von Mehrlagenschaltungen lösen sich voneinander.
Die US-A-4,165,295, die US-A-4,215,005 und Patent Abstracts of Japan, Band 14, No. 366 (P-1089) beschreiben Entschichterlösungen für gehärtete Photoresist- oder Lötstoppmasken auf der Basis organischer Lösungsmittel, die als wirkaktiven Bestandteil unter anderem Fluoridionen enthalten. Die Fluoridionen verstärken in diesen Zusammensetzungen die Entschichtungs- und Reinigungswirkung dieser Lösungen, jedoch müssen die Fluoridlösungskonzentrationen hierbei auf wenige 100 ppm, bezogen auf das Gesamtgewicht der Lösungen, begrenzt werden, da höhere Fluoridionenkonzentrationen in derartigen Zusammensetzungen zu starken Verätzungen anorganischer Substrate führen würden. Solche Verätzungen würden bei der Reinigung von Wänden, Rohrleitungen, Sprühdüsen und Heizschlangen in Verarbeitungsmaschinen und auch an den Trägermaterialien der beschichteten Leiterplatten starke Beschädigungen hervorrufen.

Aufgabe der Erfindung war es, eine Lösung vorzuschlagen, die geeignet ist, auch schwer entfernbare, z.B. thermisch vernetzte Photoresistschablonen oder Lötstoppmasken rückstandsfrei ohne Angriff auf die damit abgedeckten Leiterplatten oder Schaltungen zu entfernen. Die Lösung sollte weiterhin zur Entfernung von Rückständen in Verarbeitungsmaschinen, insbesondere Entwicklungsmaschinen, geeignet sein.

Die erfindungsgemäße Entwicklerlösung für lichtvernetzte und ggf. thermisch vernetzte Photoresistschablonen sowie für durch Belichten und Erwärmen vernetzte Lötstoppmasken, die als wesentliche Bestandteile einen Diglykolmonoalkylether, einen Glykolmonoalkylether, ein Alkali- oder Ammoniumhydroxid und Wasser enthält, enthält zusätzlich 1 - 5 Gew.-% eines wasserlöslichen Fluorids

Die Diglykolether leiten sich von Dialkylenglykolen mit 2 bis 4, bevorzugt 2 oder 3 Kohlenstoffatomen ab. Diethylenglykolether werden besonders bevorzugt, jedoch können auch Dipropylenglykolether mit Vorteil eingesetzt werden. Die Alkylethergruppe hat im allgemeinen 1 bis 4, bevorzugt 1 oder 2 Kohlenstoffatome. Der Glykolmonoalkylether kann sich von den gleichen Glykolen ableiten wie der Dialkylenglykolether. Die Alkylethergruppe des Glykolmonoalkylethers kann 1 bis etwa 6, bevorzugt 2 bis 6 Kohlenstoffatome enthalten. Als Alkalihydroxid kommt bevorzugt Natrium- der Kalium-, insbesondere Kaliumhydroxid in Betracht. Das Ammoniumhydroxid besteht bevorzugt aus einem quaternären Ammoniumhydroxid. Es kann alleine oder zusammen mit Alkalihydroxid als Hydroxidbestandteil in der Lösung vorliegen. Wesentlicher Bestandteil der Entschichterlösung ist ein wasserlösliches Fluorid, insbesondere ein Alkalifluorid, das in einem Anteil von 1 - 5 Gew.-% in der Lösung vorliegt. Auch hier wird das Natrium- oder Kaliumfluorid besonders bevorzugt. Die Lösung enthält ferner Wasser. Sie wird im allgemeinen als Konzentrat geliefert, das bei der Anwendung als solches eingesetzt oder nach Bedarf mit Wasser verdünnt werden kann. Die Mengenanteile der Bestandteile des Konzentrats liegen im allgemeinen innerhalb der folgenden Bereiche:

| | | bevorzugt |
|---|---|---|
| Diglykolmonoalkylether | 15 - 60 | 20 - 55 Gew.-% |
| Glykolmonoalkylether | 10 - 50 | 10 - 35 Gew.-% |
| Fluorid | 1 - 5 | 1 - 3 Gew.-% |
| Alkali- oder Ammonium- hydroxid | 10 - 30 | 15 - 25 Gew.-% |
| Wasser | 12 - 20 | 14 - 20 Gew.-% |

Die erfindungsgemäße Lösung wird zum Gebrauch gewöhnlich verdünnt, vorteilhaft auf das 2 bis 4-fache Volumen. Sie kann in dieser Verdünnnung entweder zum Entscnichten von lichtvernetzten Photoresistschablonen, insbesondere Lötstoppmasken, oder zum Reinigen von Geräten eingesetzt werden, in denen lichthärtbare Photoresistmateralien verarbeitet werden, z.B. von Entwicklungsmaschinen. Für besonders stark verschmutzte Geräte kann die Lösung unverdünnt zur Anwendung gelangen. Die Einwirkung erfolgt normalerweise bei erhöhter Temperatur, vorzugsweise im Bereich von 40-90 °C. Bei Geräten mit Bestandteilen aus Kunststoffen, z.B. aus Polyethylen, Polypropylen oder nachchloriertem Polyvinylchlorid sollte die Behandlungstemperatur vorzugsweise nicht höher als 50 °C liegen.

Lichthärtbare, besonders photopolymerisierbare Gemische, die sich nach der photochemischen und ggf. thermischen Härtung mit der erfindungsgemäßen Lösung entschichten lassen, sind im wesentlichen alle bekannten photopolymerisierbaren Photoresistmaterialien, insbesondere solche, die sich durch Entwickeln mit wäßrig-alkalischen Lösungen verarbeiten lassen. Die besonders hohe Wirksamkeit der Lösung kommt jedoch vor allem bei solchen Gemischen zum Tragen, die nach dem Belichten und Entwickeln noch durch Erhitzen nachgehärtet werden. Derartige Gemische werden besonders zur Herstellung von Lötstoppmasken eingesetzt, wie sie z.B. in der EP-A 418 733 beschrieben sind. Derartige Gemische enthalten im allgemeinen
a) eine Verbindung mit mindestens einer endständigen ethylenisch ungesättigten Gruppe, die durch radikalisch initiierte Additionskettenpolymerisation ein vernetztes Polymerisat zu bilden vermag,
b) ein wasserunlösliches, in wäßrig-alkalischen Lösungen lösliches polymeres Bindemittel,
c) ein feinteiliges mineralisches Pigment auf Kieselsäure- bzw. Silikatbasis,
d) einen durch Stranlung aktivierbaren Polymerisationsinitiator oder eine Polymerisationsinitiatorkombination,
e) eine Verbindung, die mit sich selbst, mit dem Bindemittel (b) oder mit dem Polymerisat der Verbindung (a) in der Wärme zu vernetzen vermag, und
f) ggf. einen durch Wärme aktivierbaren Vernetzungsinitiator für die Verbindung (e).

Das Gemisch wird in der Weise verarbeitet, daß man eine Lösung bzw. Dispersion eines Gemisches der vorstehend angegebenen Zusammensetzung auf die Oberfläche einer gedruckten Schaltung aufbringt und trocknet, die erhaltene Schicht bildmäßig mit aktinischer Strahlung unter Aussparung der Lötaugen bestrahlt, die unbestrahlten Schichtbereiche mit einem Entwickler auswäscht und die erhaltene Maske auf erhöhte Temperatur erwärmt.

Als mineralisches Pigment sind vor allem Silikate oder Kieselsäuren geeignet. Der Mengenanteil des Pigments beträgt allgemein 20 bis 50, vorzugsweise 25 bis 40 Gew.-%.

Als polymerisierbare Verbindungen werden im allgemeinen Ester der Acryl- oder Methacrylsäure mit mehrwertigen, vorzugsweise primären, Alkoholen verwendet. Der Alkohol sollte mindestens zwei Hydroxygruppen enthalten, da durch mehrfach ungesättigte Verbindungen die erwünschte Vernetzungswirkung erreicht wird. Bevorzugt werden mindestens zweifach ungesättigte Verbindungen. Die Ester des Trimethylolpropans, Trimethylolethans, des Pentaerythrits und Dipentaerythrits werden besonders bevorzugt. Das Monomere ist im allgemeinen in einer Menge von 10 bis 35, vorzugsweise von 15 bis 30 Gew.-%, bezogen auf den Gesamtgehalt an nichtflüchtigen Bestandteilen, in dem Gemisch enthalten.

Als polymere Bindemittel eignen sich vor allem Polymere mit seitenständigen Carboxyl- oder Carbonsäureanhydridgruppen. Besonders bevorzugt werden Copolymere der Acryl- und Methacrylsäure, die als Comonomere Acryl- oder Methacrylsäureester, Styrole, Acryl- oder Methacrylnitril, Acryl- odr Methacrylamid oder Vinylheterocyclen enthalten.

Als durch Strahlung aktivierbare Polymerisationsinitiatoren können zahlreiche Substanzen Verwendung finden. Beispiele sind Mehrkernchinone, wie 2-Ethylanthrachinon, Acridinderivate, wie 9-Phenylacridin oder Benzacridine, Phenazinderivate, wie 9,10-Dimethylbenz(a)phenazin, Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Bevorzugt werden Photoinitiatoren, die durch Licht spaltbare Trihalogenmethylgruppen enthalten, insbesondere Verbindungen aus der Triazin- oder Thiazolinreihe. Ein bevorzugtes Beispiel ist 2-(4-Methoxystyryl)-4,6-bis-trichlormethyl-s-triazin.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemisches, zugesetzt.

Das erfindungsgemäße Gemisch enthält ferner eine thermisch vernetzbare Verbindung. Bevorzugt werden zwei- oder mehrwertige Epoxyverbindungen. Als Beispiele sind insbesondere Bisglycidylether von zweiwertigen Alkoholen und Phenolen, wie z.B. von Bisphenol A, von Polyethylenglykol- und Polypropylenglykolethern des Bisphenols A, von Butan-1,4-diol, Hexan-1,6-diol, Polyethylenglykol, Polypropylenglykol oder Polytetrahydrofuran geeignet.

Auch Bisglycidylether von dreiwertigen Alkoholen, z.B. von Glycerin, können verwendet werden. Die Epoxide werden dem Gemisch gewöhnlich in einer Menge von etwa 10 bis 30, vorzugsweise 12 bis 25 Gew.-%, bezogen auf die nichtflüchtigen Bestandteile des Gemisches, zugesetzt.

Als weitere thermisch vernetzbaren Verbindungen sind solche mit kondensationsfähigen N-Hydroxymethyl- oder N-Alkoxymethylgruppen geeignet. Beispiele sind Hexamethoxymethyl- und Hexahydroxymethylmelamin.

Wenn als Vernetzer Epoxyverbindungen eingesetzt werden, enthält das Gemisch bevorzugt einen Härter oder Additionsinitiator für Epoxygruppen. Der Härter ist bevorzugt eine Stickstoffbase, z.B. Triethylamin, 1,4-Diazabicyclo[2.2.2]octan (Dabco), Dibutylamin oder höher alkylierte Mono-, Di- und Triamine auf aliphatischer Basis. Die Menge der Base liegt im allgemeinen zwischen 0,15 und 1,5, vorzugsweise zwischen 0,2 und 1,0 Gew.-%.

Als Entwickler sind vorzugsweise wäßrig-alkalische Lösungen, z.B. von Alkaliphosphaten, -carbonaten oder -silikaten, geeignet, denen gegebenenfalls kleine Mengen, z.B. bis zu 10 Gew.-%, an mit Wasser mischbaren organischen Lösemitteln oder Netzmitteln zugesetzt werden können.

Fertig entwickelte Lötmasken werden vor dem Lötprozeß einer Temperaturbehandlung unterzogen. Dabei reagieren z.B. die Carboxylgruppen des Bindemittels mit dem mehrfunktionellen Epoxid zu einem interpenetrierenden Netzwerk. Integrierender Bestandteil dieses Netzwerkes ist auch der mineralische Feststoff.

Insgesamt werden durch die thermische Nachbehandlung die guten mechanischen, thermischen und chemischen Eigenschaften der Lötstoppmasken bewirkt. Diese thermische Behandlung erfolgt im allgemeinen zwischen 80 °C und 180 °C, bei ungefähren Behandlungszeiten von 10 bis 90 Minuten. Die lötbereite Platte wird anschließend verzinnt. und kann dann mit elektronischen Bauelementen in bekannter Weise bestückt werden.

Die Leitungsseite der Platte wird anschließend üblicherweise mit einem passenden, handelsüblichen Flußmittel behandelt und z.B. über eine handelsübliche Schwall-Lötmaschine der Schwall-Lötung unterworfen. Als Lötmittel dienen bekannte eutektische Gemische, die Löttemperaturen von etwa 230 bis 260 °C gestatten.

Die belichteten und entwickelten Schichten lassen sich thermisch härten. Die gehärteten Masken sind gegenüber atmospärischen, thermischen und chemischen Einflüssen über längere Zeiträume beständig.

Das folgende Beispiel erläutert die Erfindung. Wenn nichts anderes angegeben ist, sind Prozentzahlen und Mengenverhältnise in Gewichtsteilen zu verstehen. Gewichtsteile (Gt) und Volumenteile (Vt) stehen im Verhältnis von g zu ml.

### Beispiel

In einem zylindrischen Gefäß wurden in 123,9 Gt 3-Methoxy-butanol-1
112,5 Gt Pentaerythrit-triacrylat,
128,9 Gt Trimethylolpropan-triacrylat,
27,5 Gt 9-Phenylacridin,
12,4 Gt Neozapongrün,
1,2 Gt eines blauen Azofarbstoffs,
2,5 Gt Triethylendiamin
mit einem hochtourigen Schnellrührer in Lösung gebracht. Dann wurden im Verlauf von 30 Minuten 396,7 Gt eines silikatischen Pigments, das ein natürliches Agglomerat von korpuskularem Quarz und laminarem Kaolinit ist, in die gerührte Lösung eingestreut. Dieser Suspension wurden anschließend 694,2 Gt einer 53 %-igen Lösung eines Terpolymeren aus Styrol, Methacrylsäure und n-Hexylmethacrylat (32: 15 : 3) zugesetzt und die Mischung gut homogenisiert.

Der viskose Lack wurde in einer Glaskugelmühle vermahlen und dann durch ein 160 µm V2A-Gewebe-Druckfilter filtriert und abgefüllt.

252 Gt eines epoxydierten Phenol-Formaldehyd-Harzes mit dem Epoxid-Äquivalentgewicht 172 bis 179 wurden in 148 Gt 3-Methoxybutanol mittels eines Ankerrührers gelöst. Nach 15 Minuten Rührzeit lag eine klare Lösung mit 63 % Feststoffgehalt vor.

100 Gt der ersten Lösung wurden mit 22,3 Gt der Epoxidharzlösung intensiv gemischt. Der Feststoffgehalt der Mischung betrug 67,5 %.

Eine 24 x 36 cm große Platte aus Epoxidharz-Glasgewebe mit einem beidseitig aufgebrachten Schaltbild aus 0,2 bis 1,5 mm breiten und 50 bis 90 µm dicken Kupferbahnen und durchkontaktierten Bohrungen wurde mit der vorstehend beschriebenen Lösung mittels einer halbautomatischen Siebdruckmaschine vollflächig beschichtet. Die so beschichtete Leiterplatte wurde 5 Minuten bei Raumtemperatur belassen und anschließend 7 Minuten in einem Umlufttrockenschrank bei 80 °C getrocknet. Nach dem Abkühlen auf Raumtemperatur wurde die beschichtete Leiterplatte durch eine Filmvorlage bildmäßig belichtet.

Entwickelt wurde innerhalb 90 s in einer Durchlaufsprühanlage mit 1 %-iger wäßriger Sodalösung bei 30 °C mit 1,2 bar Sprühdruck.

Nach Waschen mit Wasser wurde die entwickelte Platte in einem Warmluftdurchlauftrockner getrocknet und anschließend in einem Umlufttrockenofen 1 Stunde bei 150 °C getempert. Die nun vollständig ausgehärtete Platine wurde schwallgelötet. Dazu wurde die Platte über einen vorgeschalteten Schaumfluxer (Alphagrillo^{(R)}TL 33) geführt, vorgetrocknet und über das aus eutektischer Blei/Zinnlegierung bestehende flüssige Lot gefahren. Die Geschwindigkeit betrug 0,9 m je Minute, die Lottemperatur 260 °C.
Die erhaltene, an den nicht gelöteten Stellen mit einer Lötstoppmaske abgedeckte Schaltung wurde zur Entfernung der Lötstoppmaske mit einer Lösung behandelt, die durch Verdünnen eines Konzentrats aus
17,4 Gt Wasser,
15,0 Gt KOH,
50,0 Gt Diethylenglykolmonoethylether,
15,0 Gt Ethylenglykolmonobutylether und
2,6 Gt KF

auf das dreifache Volumen mit Wasser erhalten worden war. Die Behandlung erfolgte bei 70 °C und war nach 15 Minuten beendet. Eine Inspektion der Plattenoberfläche zeigte, daß die Maske rückstandsfrei entfernt war. Die Oberfläche des Leiterplattenträgermaterials war an keiner Stelle angegriffen.
Die Schaltung konnte nach gründlichem Spülen mit Wasser und Trocknen erneut mit einer Lötstoppmaske beschichtet werden.

In einem weiteren Versuch wurden 30 l der oben beschriebenen Lösung auf das doppelte Volumen mit Wasser verdünnt und in eine stark durch Rückstände an Wänden, in Rohrleitungen und Düsen verunreinigte Sprühentwicklungsvorrichtung in der über längere Zeit Lötstoppmasken der oben beschriebenen Art entwickelt worden waren, gegeben und darin etwa 60 Minuten bei 50 °C umgepumpt. Nach dieser Zeit harten sich alle Abscheidugen gelöst, und die Vorrichtung konnte nach Spülen mit Wasser wieder in Betrieb genommen werden.

## Patentansprüche

1. Entschichterlösung für lichtvernetzte und ggf. thermisch vernetzte Photoresistschablonen sowie für durch Belichten und Erwärmen vernetzte Lötstoppmasken, die als wesentliche Bestandteile einen Diglykolmonoalkylether, einen Glykolmonoalkylether, ein Alkali- oder Ammoniumhydroxid und Wasser enthält, **dadurch gekennzeichnet**, daß sie zusätzlich 1 - 5 Gew.-% eines wasserlöslichen Fluorids enthält.

2. Entschichterlösung nach Anspruch 1, **dadurch gekennzeichnet**, daß das wasserlösliche Fluorid ein Alkalifluorid ist.

3. Entschichterlösung nach einem der Ansprüche 1 oder 2, **dadurch gekennzeichnet**, daß der Diglykolmonoalkylether eine Alkylethergruppe mit 1 bis 4 Kohlenstoffatomen enthält.

4. Entschichterlösung nach einem der Ansprüche 1 bis 3, **dadurch gekennzeichnet**, daß der Glykolmonoalkylether eine Alkylethergruppe mit 1 bis 6 Kohlenstoffatomen enthält.

5. Entschichterlösung nach einem der Ansprüche 1 bis 4, **dadurch gekennzeichnet**, daß sie 15 bis 60 Gew.-% Diglykolmonoalkylether, 10 bis 50 Gew.-% Glykolmonoalkylether, 10 bis 30 Gew.-% Alkali- oder Ammoniumhydroxid und 12 bis 20 Gew.-% Wasser enthält.

## Claims

1. Stripper solution for photocrosslinked and optionally thermally crosslinked photoresist masks and for soldering masks crosslinked by exposure to light and heating and containing a diglycol monoalkyl ether, a glycol monoalkyl ether, an alkali metal or ammonium hydroxide and water as essential components, characterized in that it additionally contains 1 - 5% by weight of a water-soluble fluoride.

2. Stripper solution according to Claim 1, characterized in that the water-soluble fluoride is an alkali metal fluoride.

3. Stripper solution according to either of Claims 1 and 2, characterized in that the diglycol monoalkyl ether contains an alkyl ether group having 1 to 4 carbon atoms.

4. Stripper solution according to any of Claims 1 to 3, characterized in that the glycol monoalkyl ether contains an alkyl ether group having 1 to 6 carbon atoms.

5. Stripper solution according to any of Claims 1 to 4, characterized in that it contains 15 to 60% by weight of diglycol monoalkyl ether, 10 to 50% by weight of diglycol monoalkyl ether, 10 to 30% by weight of alkali metal or ammonium hydroxide and 12 to 20% by weight of water.

## Revendications

1. Solution de décapage pour des pochoirs de photoréserves photoréticulées et éventuellement thermiquement réticulées ainsi que pour des masques d'arrêt de brasage réticulés par exposition à la lumière et chauffage, qui contient comme constituants principaux un diglycolmonoalkyléther, un glycolmonoalkyléther, un hydroxyde d'alcali ou d'ammonium et de l'eau, caractérisée en ce qu'elle contient en outre 1-5 % en poids d'un fluorure soluble dans l'eau.

2. Solution de décapage selon la revendication 1, caractérisée en ce que le fluorure soluble dans l'eau est un fluorure d'alcali.

3. Solution de décapage selon l'une des revendications 1 ou 2, caractérisée en ce que le diglycolmonoalkyléther contient un groupe alkyléther avec de 1 à 4 atomes de carbone.

4. Solution de décapage selon l'une des revendications 1 à 3, caractérisée en ce que le glycolmonoalkyléther contient un groupe alkyléther avec de 1 à 6 atomes de carbone.

5. Solution de décapage selon l'une des revendications 1 à 4, caractérisée en ce qu'elle contient de 15 à 60 % en poids de diglycolmonoalkyléther, de 10 à 50 % en poids de glycolmonoalkyléther, de 10 à 30 % en poids d'hydroxyde d'alcali ou d'ammonium et de 12 à 20 % en poids d'eau.
